# EUROPEAN PATENT SPECIFICATION

(11) **EP 4 421 943 B1**
(45) Date of publication and mention of the grant of the patent: **03.12.2025**
(21) Application number: 24152136.8
(22) Date of filing: 16.01.2024
(51) Int. Cl.: H01M 10/42, H01M 10/48, H01M 50/503, H01M 50/507, H01M 50/569

(54) **BATTERY SENSING UNIT AND BATTERY MODULE INCLUDING THE SAME**
BATTERIEERFASSUNGSEINHEIT UND BATTERIEMODUL DAMIT
UNITÉ DE DÉTECTION DE BATTERIE ET MODULE DE BATTERIE LA COMPRENANT

(30) Priority: 16.02.2023 KR 20230020752
(43) Date of publication of application: 28.08.2024
(73) Proprietor: SK On Co., Ltd., Seoul 03161 (KR)
(72) Inventor: JO, Soo Hwan, 34124 Daejeon (KR); KANG, Ji Eun, 34124 Daejeon (KR); KANG, In Seob, 34124 Daejeon (KR); LEE, Hee Jin, 34124 Daejeon (KR)
(74) Representative: Bird & Bird LLP

(56) References cited:
- EP-A1- 3 565 022
- EP-B1- 3 591 732
- WO-A1-2010/113455
- WO-A1-2022/009667
- KR-A- 20190 061 378
- US-A1- 2021 119 309

## Description

### TECHNICAL FIELD

The technology and implementations disclosed in this patent document generally relate to a battery sensing unit and a battery module including the same.

### BACKGROUND

A battery module may include a battery sensing unit that is connected to bus bars to perform a battery sensing operation. Bus bars connect battery cells in the battery module and allow current to flow from and to the individual battery cells.

(Patent Document 1) US 9516231 B2

Prior art documents EP 3 565 022, WO 2010/113455, US 2021/119309, WO 2022/009667, EP 3 591 732, KR 2019 0061378 disclose sensing assemblies for battery units.

### SUMMARY

The disclosed technology can be implemented in some embodiments to provide a battery sensing unit that is formed as a unibody and has improved durability, and a battery module including the same.

In addition, the disclosed technology can be implemented in some embodiments to provide a battery sensing unit, that is folded and bent, and a battery module including the same.

In one aspect of the disclosed technology, a battery sensing unit forming one plane may comprise a sensing body extending in a transverse direction; a first sensing bridge extending forward from a first end of the sensing body; a second sensing bridge extending forward from a second end of the sensing body; a first sensing connector forming a shape extending from an end of the first sensing bridge toward the second sensing bridge; and a second sensing connector forming a shape extending from an end of the second sensing bridge toward the first sensing bridge, wherein the first sensing connector is positioned between the sensing body and the second sensing connector.

When each of the first sensing bridge and the second sensing bridge is folded, each of the first sensing connector and the second sensing connector may form a shape extending in a longitudinal direction.

The battery sensing unit may include a first face and a second face formed opposite the first face. In a state in which each of the first sensing bridge and the second sensing bridge is folded, the first face of the sensing body may face upward, and each of the first face of the first sensing connector and the first face of the second sensing connector may face downward.

In a state in which each of the first sensing bridge and the second sensing bridge is folded, the sensing body may be disposed between the first sensing connector and the second sensing connector.

In a state in which each of the first sensing bridge and the second sensing bridge is bent, the first sensing connector and the second sensing connector may face each other.

The first sensing bridge may be bent between a folded portion of the first sensing bridge and the first sensing connector, and the second sensing bridge may be bent between a folded portion of the second sensing bridge and the second sensing connector.

The battery sensing unit may further comprise at least one of a first sensing extension positioned between the sensing body and the first sensing connector and extending from the first sensing connector, or a second sensing extension positioned between the sensing body and the first sensing connector and extending from the sensing body.

The sensing body, the first sensing bridge, the second sensing bridge, the first sensing connector, and the second sensing connector may be formed as a unibody.

The sensing body, the first sensing bridge, the second sensing bridge, the first sensing connector, and the second sensing connector may include a flexible printed circuit board (FPCB).

In another aspect of the disclosed technology, a battery module may comprise a battery cell assembly including a plurality of battery cells disposed in a front-rear direction, each of the plurality of battery cells including a first electrode lead and a second electrode lead that protrude in a transverse direction and are formed opposite to each other; a first bus bar unit coupled to the first electrode lead; a second bus bar unit coupled to the second electrode lead; and a battery sensing unit configured to connect the first bus bar unit and the second bus bar unit, wherein the battery sensing unit includes a first sensing connector coupled to the first bus bar unit, a second sensing connector coupled to the second bus bar unit, a sensing body extending in the transverse direction, a first sensing bridge configured to connect a first end of the sensing body and the first sensing connector, the first sensing bridge being folded and bent, and a second sensing bridge configured to connect a second end of the sensing body and the second sensing connector, the second sensing bridge being folded and bent.

The sensing body, the first sensing bridge, the second sensing bridge, the first sensing connector, and the second sensing connector may be formed as a unibody.

The first sensing bridge may be bent between a folded portion of the first sensing bridge and the first sensing connector, and the second sensing bridge may be bent between a folded portion of the second sensing bridge and the second sensing connector.

The battery sensing unit may further include at least one of a first sensing extension positioned between the sensing body and the first sensing connector and extending from the first sensing connector, or a second sensing extension positioned between the sensing body and the first sensing connector and extending from the sensing body.

The battery module may further comprise at least one of a first temperature sensor connected to the first sensing extension, or a second temperature sensor connected to the second sensing extension.

The first temperature sensor may be positioned on a front face of the battery cell assembly, and the second temperature sensor may be positioned on an upper face of the battery cell assembly. Each temperature sensor is used to measure a temperature of the battery cell assembly.

The disclosed technology can be implemented in some embodiments to provide a battery sensing unit that is formed as a unibody and has improved durability, and a battery module including the battery sensing unit that is formed as a unibody.

The disclosed technology can be implemented in some embodiments to provide a battery sensing unit that is folded and bent, and a battery module including the battery sensing unit that is folded and bent.

A battery sensing unit and a battery module including the battery sensing unit based on some embodiments of the disclosed technology can be widely applied in green technology fields such as electric vehicles, battery charging stations, and other battery-based solar power generation and wind power generation.

A battery sensing unit and a battery module including the battery sensing unit based on some embodiments of the disclosed technology can be used in eco-friendly electric vehicles, hybrid vehicles, etc. to prevent climate change by suppressing air pollution and greenhouse gas emissions.

### BRIEF DESCRIPTION OF THE DRAWINGS

The accompanying drawings illustrate examples of embodiments of various technical features disclosed in the disclosure.
FIG. 1 illustrates a battery module based on an embodiment of the disclosed technology.
FIG. 2 is an exploded perspective view of a battery module illustrated in FIG. 1.
FIG. 3 illustrates a battery module including a battery sensing unit that is folded and bent based on an embodiment of the disclosed technology.
FIG. 4 is an exploded perspective view of a battery module illustrated in FIG. 3.
FIG. 5 illustrates a battery sensing unit forming one plane based on an embodiment of the disclosed technology.
FIG. 6 illustrates a portion "A" illustrated in FIG. 5.
FIG. 7 illustrates a portion "B" illustrated in FIG. 5.
FIG. 8 illustrates that a battery sensing unit illustrated in FIG. 5 is folded along a fold line positioned on a sensing bridge.
FIG. 9 is a cross-sectional view of a battery sensing unit taken along C1-C2 of FIG. 8.
FIG. 10 is a cross-sectional view of a battery sensing unit taken along D1-D2 of FIG. 8.
FIG. 11 illustrates an example where a battery sensing unit illustrated in FIG. 8 is bent.
FIG. 12 illustrates an example where an unfolded battery sensing unit is formed on one plane.

### DETAILED DESCRIPTION

Reference will now be made in detail to embodiments of the disclosed technology, examples of which are illustrated in the accompanying drawings. However, the following description is merely an example and does not intended to limit the disclosed technology to a specific implementation.

The disclosed technology can be implemented in some embodiments to provide a battery sensing unit connected to bus bars by attaching a plurality of separate parts to each other. The disclosed technology can be implemented in some embodiments to reduce the complexity of the overall manufacturing process that would have been caused by a process for attaching the plurality of parts. In addition, the disclosed technology can be implemented in some embodiments to prevent connection portions of the plurality of parts from being damaged, and to improve the durability of the battery sensing unit.

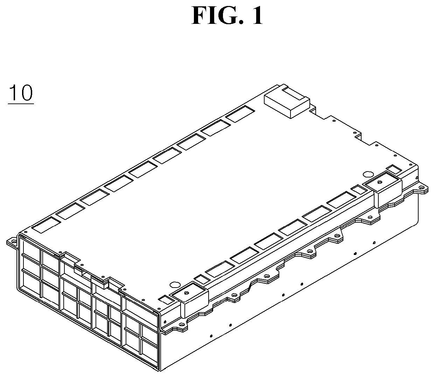

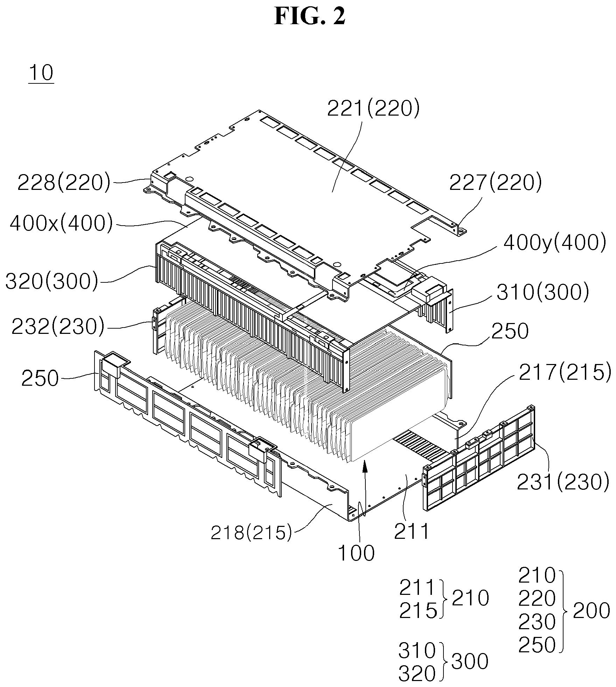

FIG. 1 illustrates a battery module 10 based on an embodiment of the disclosed technology. FIG. 2 is an exploded perspective view of the battery module 10 illustrated in FIG. 1. In some embodiments of the disclosed technology, an up-down direction and a front-rear direction may be set based on FIG. 2.

Referring to FIGS. 1 and 2, the battery module 10 may include a battery cell assembly 100. The battery cell assembly 100 may include a plurality of battery cells. The plurality of battery cells may be arranged or stacked in one direction. For example, a direction in which the plurality of battery cells are arranged or stacked may be a longitudinal direction or a length direction of the battery module 10. The longitudinal direction of the battery module 10 may be the front-rear direction of the battery module 10.

Each of the plurality of battery cells may include a battery cell body. The battery cell body may extend from one end of a battery cell and lead to another end of the battery cell. In some embodiments, one end of the battery cell body may be referred to as a "first end" of the battery cell body, and the other end of the battery cell body may be referred to as a "second end" of the battery cell body.

For example, the battery cell body may form a shape extending in a width direction or a transverse direction of the battery module 10. In other words, the longitudinal direction or the length direction of the battery cell body may be the width direction or the transverse direction of the battery module 10.

Each of the plurality of battery cells may include an electrode lead. The electrode lead may form a shape extending from the battery cell body. For example, the electrode lead may form a shape protruding from the battery cell body. For example, the electrode lead may include a first electrode lead protruding from the first end of the battery cell body. For example, the electrode lead may include a second electrode lead protruding from the second end of the battery cell body.

The battery cell assembly 100 may include a heat shield pad. The heat shield pad may be disposed between the plurality of battery cells. When thermal runaway occurs in one battery cell among the plurality of battery cells, the heat shield pad may prevent heat or flame from moving from the one battery cell, in which the thermal runaway occurs, to battery cells around the one battery cell. The heat shield pad may include a heat resistant material.

The battery module 10 may include a case 200. The case 200 may be referred to as a "battery case." The case 200 may include a first case 210. The first case 210 may accommodate the battery cell assembly 100.

The first case 210 may include a bottom case 211. The bottom case 211 may form the bottom of the case 200. The bottom case 211 may be positioned under the battery cell assembly 100.

In other words, the battery cell assembly 100 may be loaded on the bottom case 211. The bottom case 211 may form a shape of a plate. The bottom case 211 may be referred to as a "bottom plate." In some implementations, the term "case" can be used to indicate a part of a wall of a case. For example, the terms "top case" and "bottom case" can be used to indicate a top wall and a bottom wall of a case, respectively. As another example, the terms "front case" and "rear case" can be used to indicate a front wall and a rear wall of a case, respectively.

The bottom plate 211 may include four edges. The four edges of the bottom plate 211 may form a perimeter of the bottom plate 211. Two connection edges of the bottom plate 211 may be two edges extending along the longitudinal direction of the battery module 10 among the four edges of the bottom plate 211.

In some implementations, the term "first connection edge" of the bottom plate 211 may be used to indicate a connection edge adjacent to the first end of the battery cell body among the two connection edges of the bottom plate 211. The first connection edge of the bottom plate 211 may extend rearward from one end of a front edge of the bottom plate 211 and lead to one end of a rear edge of the bottom plate 211.

In some implementations, the term "second connection edge" of the bottom plate 211 may be used to indicate a connection edge adjacent to the second end of the battery cell body among the two connection edges of the bottom plate 211. The second connection edge of the bottom plate 211 may extend rearward from another end of the front edge of the bottom plate 211 and lead to another end of the rear edge of the bottom plate 211.

The first connection edge and the second connection edge of the bottom plate 211 may be parallel to each other.

The first case 210 may include a side case 215. The side case 215 may extend upward from the bottom plate 211. The side case 215 may be formed as a unibody with the bottom plate 211.

A plurality of side cases 215 may be provided. For example, the side cases 215 may include a first side case 217 extending upward from the first connection edge of the bottom plate 211.

For example, the side cases 215 may include a second side case 218 extending upward from the second connection edge of the bottom plate 211. The second side case 218 may face the first side case 217. A direction from the first side case 217 to the second side case 218 may be parallel to the transverse direction of the battery module 10.

The case 200 may include a second case 220. The second case 220 may include a top case 221. The top case 221 may be formed of a material containing metal. The top case 221 may be referred to as an "upper cover."

The top case 221 may include four edges. The four edges of the top case 221 may form a perimeter of the top case 221. Two connection edges of the top case 221 may be two edges extending along the longitudinal direction of the battery module 10 among the four edges of the top case 221.

In some implementations, the term "first connection edge" of the top case 221 may be used to indicate a connection edge adjacent to the first end of the battery cell body among the two connection edges of the top case 221. In some implementations, the term "second connection edge" of the top case 221 may be used to indicate a connection edge adjacent to the second end of the battery cell body among the two connection edges of the top case 221. The first connection edge and the second connection edge of the top case 221 may be parallel to each other.

The second case 220 may include wing cases 227 and 228. The wing cases 227 and 228 may be formed as a unibody with the top case 221. The wing cases 227 and 228 may extend downward from the edges of the top case 221.

For example, the wing cases 227 and 228 may include a first wing case 227 extending downward from the first connection edge of the top case 221. For example, the wing cases 227 and 228 may include a second wing case 228 extending downward from the second connection edge of the top case 221.

The wing cases 227 and 228 may be coupled or fastened to the side cases 215. For example, the first wing case 227 may be coupled or fastened to the first side case 217. For example, the second wing case 228 may be coupled or fastened to the second side case 218.

The case 200 may include front and rear cases 230. The front and rear cases 230 may include a front case 231. The front case 231 may face the battery cell assembly 100. The front case 231 may be positioned in front of the battery cell assembly 100.

The front case 231 may be connected or coupled to a front end of the first side case 217. The front case 231 may be connected or coupled to a front end of the second side case 218. The front case 231 may be connected or coupled to a front end of the bottom case 211. The front case 231 may be referred to as a "first cover plate."

The front and rear cases 230 may include a rear case 232. The rear case 232 may face the battery cell assembly 100. The rear case 232 may be positioned behind the battery cell assembly 100.

The rear case 232 may be connected or coupled to a rear end of the first side case 217. The rear case 232 may be connected or coupled to a rear end of the second side case 218. The rear case 232 may be connected or coupled to a rear end of the bottom case 211. The rear case 232 may be referred to as a "second cover plate."

The front and rear cases 230 may be referred to as "cover plates." The cover plate 230 may indicate at least one of the first cover plate 231 and the second cover plate 232.

The case 200 may include an insulating cover 250. The insulating cover 250 may be disposed between the battery cell assembly 100 and the side case 215. The insulating cover 250 may include an insulating material.

The battery module 10 may include a bus bar unit 300. The bus bar unit 300 may be electrically connected to the battery cell assembly 100. The bus bar unit 300 may be disposed between the battery cell assembly 100 and the case 200. The bus bar unit 300 may electrically connect the plurality of battery cells. A plurality of bus bar units 300 may be provided.

For example, the bus bar unit 300 may include a first bus bar unit 310 disposed between the first side case 217 and the battery cell assembly 100. The first bus bar unit 310 may electrically connect the first electrode leads of the plurality of battery cells.

For example, the bus bar unit 300 may include a second bus bar unit 320 disposed between the second side case 218 and the battery cell assembly 100. The second bus bar unit 320 may electrically connect second electrode leads of the plurality of battery cells.

The battery module 10 may include a battery sensing unit 400. The battery sensing unit 400 may include a sensing frame 400x. The sensing frame 400x may connect the first bus bar unit 310 and the second bus bar unit 320.

The sensing frame 400x may be positioned between the battery cell assembly 100 and the top case 221. The sensing frame 400x may form a shape of a plate or board.

The battery sensing unit 400 may include a battery sensor 400y. The battery sensor 400y may be connected or fixed to the sensing frame 400x. The battery sensor 400y may be connected to the bus bar unit 300.

For example, the battery sensor 400y may be electrically connected to the bus bar unit 300. For example, the battery sensor 400y may be electrically connected to the first bus bar unit 310 and electrically connected to the second bus bar unit 320.

For example, the battery sensor 400y may obtain a signal from the bus bar unit 300. For example, the battery sensor 400y may obtain an electrical signal from the bus bar unit 300. For example, the battery sensor 400y may obtain an electrical signal from the bus bar unit 300 by detecting current or voltage of the bus bar. The electrical signal obtained by the battery sensor 400y may be a current or a voltage. Hence, the battery sensor 400y may obtain information on charge and discharge states of the battery cell assembly 100. For example, the charge/discharge status of the battery cell assembly 100 may be determined based on the electrical signal obtained by the battery sensor 400y from the bus bar unit by detecting current or electric potential of the bus bar.

For example, the battery sensor 400y may include a temperature sensor. For example, the temperature sensor included in the battery sensor 400y may obtain temperature information of the battery cell assembly 100.

The battery sensor 400y may be connected to an external device. For example, the battery sensor 400y may be connected to a battery management system (BMS). For example, the battery sensor 400y may transmit information on the battery cell assembly 100 to the BMS. The information on the battery cell assembly 100 may include at least one of information on the charge/discharge state of the battery cell assembly 100 or information on the temperature of the battery cell assembly 100.

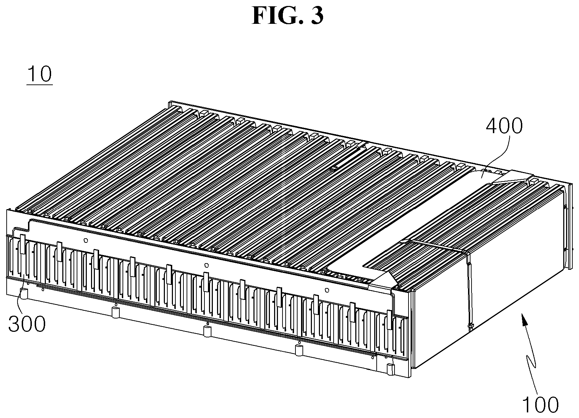

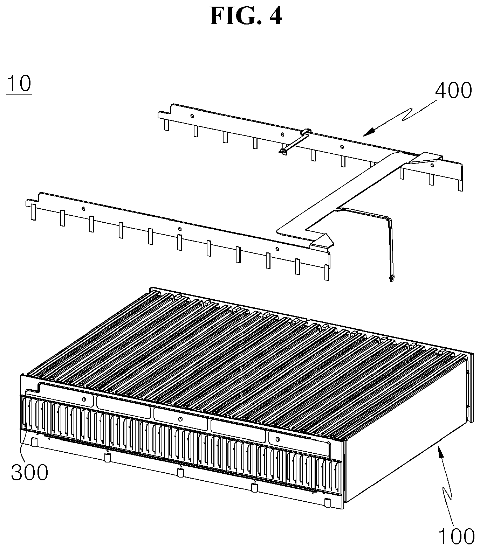

FIG. 3 illustrates a battery module including a battery sensing unit that is folded and bent based on an embodiment of the disclosed technology. For convenience of explanation, the illustration of the case 200 (see FIG. 2) may be omitted in FIG. 3. FIG. 4 is an exploded perspective view of a battery module illustrated in FIG. 3.

Referring to FIGS. 3 and 4, the battery sensing unit 400 may include a flexible printed circuit board (FPCB). The FPCB is bendable. The FPCB is foldable.

The bus bar unit 300 may be coupled to the battery cell assembly 100 formed by stacking the plurality of battery cells. One side of the battery sensing unit 400 may be connected to the first bus bar unit 310 (see FIG. 2), and other side of the battery sensing unit 400 may be connected to the second bus bar unit 320 (see FIG. 2).

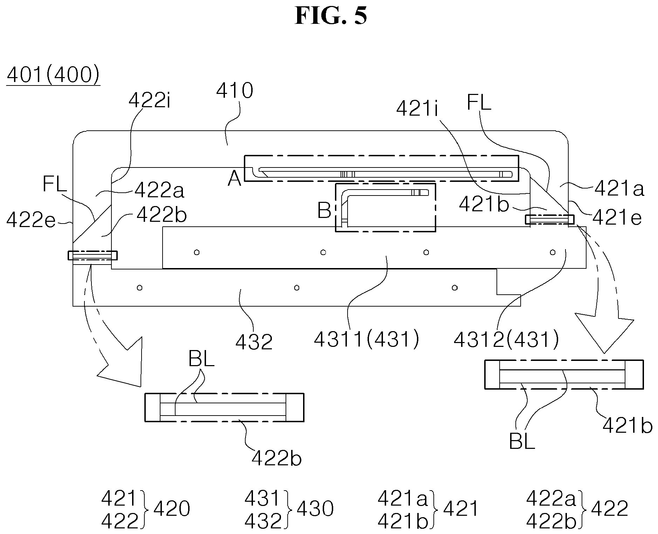

FIG. 5 illustrates a battery sensing unit forming one plane based on an embodiment of the disclosed technology.

Referring to FIG. 5, the battery sensing unit 400 may form one plane. For example, the battery sensing unit 400 may have a sheet shape. For example, the battery sensing unit 400 may include a sheet shaped FPCB.

For example, the battery sensing unit 400 may form both faces. For example, a first face 401 of the battery sensing unit 400 may be observed in FIG. 5. Both faces of the battery sensing unit 400 may be formed opposite to each other.

The battery sensing unit 400 may include a sensing body 410. The sensing body 410 may form an extended or elongated shape in one direction. An extended or elongated direction of the sensing body 410 may be a longitudinal direction of the sensing body 410.

The longitudinal direction of the sensing body 410 may be parallel to a direction from the first bus bar unit 310 (see FIG. 2) to the second bus bar unit 320 (see FIG. 2). For example, the longitudinal direction of the sensing body 410 may be the transverse direction of the battery module 10.

A first end of the sensing body 410 may be adjacent to the first bus bar unit 310 (see FIG. 2). A second end of the sensing body 410 may be adjacent to the second bus bar unit 320 (see FIG. 2).

The battery sensing unit 400 may include a sensing bridge 420. The sensing bridge 420 may form a shape extending from the sensing body 410. For example, the sensing bridge 420 may extend from the end of the sensing body 410.

The sensing bridge 420 may include a first sensing bridge 421. The first sensing bridge 421 may extend in one direction from the first end of the sensing body 410. For example, the first sensing bridge 421 may form a shape extending in the longitudinal direction of the battery module 10 (see FIG. 2) at the first end of the sensing body 410. For example, the first sensing bridge 421 may form a shape extending forward from the first end of the sensing body 410.

The sensing bridge 420 may include a second sensing bridge 422. The second sensing bridge 422 may extend in one direction from the second end of the sensing body 410. For example, the second sensing bridge 422 may form a shape extending in the longitudinal direction of the battery module 10 (see FIG. 2) at the second end of the sensing body 410. For example, the second sensing bridge 422 may form a shape extending forward from the second end of the sensing body 410.

An extended length of the first sensing bridge 421 may be different from an extended length of the second sensing bridge 422. For example, a length of the first sensing bridge 421 extending forward from the sensing body 410 may be less than a length of the second sensing bridge 422 extending forward from the sensing body 410.

The battery sensing unit 400 may be foldable. For example, the battery sensing unit 400 may be folded along a fold line FL. For example, the sensing bridge 420 may be folded along the fold line FL formed or positioned on the sensing bridge 420. The fold line FL may be a virtual line.

The sensing bridge 420 may be divided into two portions by the fold line FL formed on the sensing bridge 420. For example, the first sensing bridge 421 may include a first sensing bridge proximal portion 421a and a first sensing bridge distal portion 421b. For example, the second sensing bridge 422 may include a second sensing bridge proximal portion 422a and a second sensing bridge distal portion 422b.

A boundary between the first sensing bridge proximal portion 421a and the first sensing bridge distal portion 421b may be a fold line FL positioned on the first sensing bridge 421. A boundary between the second sensing bridge proximal portion 422a and the second sensing bridge distal portion 422b may be a fold line FL positioned on the second sensing bridge 422.

The first sensing bridge proximal portion 421a may be connected to the first end of the sensing body 410. The second sensing bridge proximal portion 422a may be connected to the second end of the sensing body 410.

The battery sensing unit 400 may include a sensing connector 430. The sensing connector 430 may extend from the sensing bridge 420. For example, the sensing connector 430 may extend from an end of the sensing bridge 420 in the longitudinal direction of the sensing body 410.

For example, the sensing connector 430 may include a second sensing connector 432. The second sensing connector 432 may extend from an end of the second sensing bridge 422. For example, the second sensing connector 432 may extend from the end of the second sensing bridge 422 toward the first sensing bridge 421.

For example, the sensing connector 430 may include a first sensing connector 431. The first sensing connector 431 may extend from an end of the first sensing bridge 421. For example, the first sensing connector 431 may include a first sensing main connector 4311 extending from the end of the first sensing bridge 421 toward the second sensing bridge 422. For example, the first sensing connector 431 may include a first sensing extension connector 4312 extending or protruding from the end of the first sensing bridge 421 in a direction opposite to a direction in which the first sensing main connector 4311 extends.

The first sensing main connector 4311 and the sensing body 410 may be spaced apart from each other. The first sensing connector 431 may be positioned between the sensing body 410 and the second sensing connector 432. For example, the first sensing main connector 4311 may be positioned between the sensing body 410 and the second sensing connector 432.

The battery sensing unit 400 may be bendable. For example, the battery sensing unit 400 may be bent along a bending line BL. For example, the sensing bridge 420 may be bent along the bending line BL formed or positioned on the sensing bridge 420. The bending line BL may be a virtual line.

The bending line BL positioned on the sensing bridge 420 may be positioned in the sensing bridge distal portions 421b and 422b. The sensing bridge distal portions 421b and 422b may include or indicate at least one of the first sensing bridge distal portion 421b and the second sensing bridge distal portion 422b.

The bending line BL positioned on the sensing bridge 420 may be adjacent to a boundary between the sensing bridge 420 and the sensing connector 430. For example, the bending line BL positioned on the first sensing bridge 421 may be adjacent to a boundary between the first sensing bridge 421 and the first sensing connector 431. For example, the bending line BL positioned on the second sensing bridge 422 may be adjacent to a boundary between the second sensing bridge 422 and the second sensing connector 432.

The bending line BL and the fold line FL positioned on the sensing bridge 420 may form an angle. For example, a distance between the bending line BL and the fold line FL positioned on the sensing bridge 420 may increase as it goes from an outer edge to an inner edge of the sensing bridge 420.

For example, a distance between the bending line BL and the fold line FL positioned on the first sensing bridge 421 may increase as it goes from an outer edge 421e to an inner edge 421i of the first sensing bridge 421.

For example, a distance between the bending line BL and the fold line FL positioned on the second sensing bridge 422 may increase as it goes from an outer edge 422e to an inner edge 422i of the second sensing bridge 422.

For example, in the bending line BL and the fold line FL positioned on the sensing bridge 420, a distance between the bending line BL and the fold line FL at the outer edge of the sensing bridge 420 may be less than a distance between the bending line BL and the fold line FL at the inner edge of the sensing bridge 420.

For example, a distance between the bending line BL and the fold line FL at the outer edge 421e of the first sensing bridge 421 may be less than a distance between the bending line BL and the fold line FL at the inner edge 421i of the first sensing bridge 421.

For example, a distance between the bending line BL and the fold line FL at the outer edge 422e of the second sensing bridge 422 may be less than a distance between the bending line BL and the fold line FL at the inner edge 422i of the second sensing bridge 422.

For example, a length of the outer edge 421e of the first sensing bridge proximal portion 421a may be greater than a length of the inner edge 421i of the first sensing bridge proximal portion 421a. For example, a length of the outer edge 422e of the second sensing bridge proximal portion 422a may be greater than a length of the inner edge 422i of the second sensing bridge proximal portion 422a.

For example, a length of the outer edge 421e of the first sensing bridge distal portion 421b may be less than a length of the inner edge 421i of the first sensing bridge distal portion 421b. For example, a length of the outer edge 422e of the second sensing bridge distal portion 422b may be less than a length of the inner edge 422i of the second sensing bridge distal portion 422b.

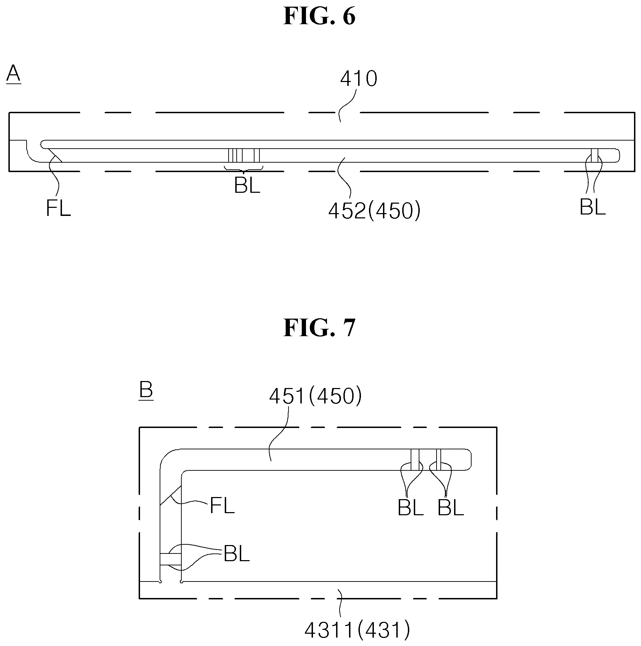

FIG. 6 illustrates a portion "A" illustrated in FIG. 5. FIG. 7 illustrates a portion "B" illustrated in FIG. 5.

Referring to FIGS. 5 to 7, the battery sensing unit 400 may include a sensing extension 450. The sensing extension 450 may be coupled to the temperature sensor. For example, the sensing extension 450 may be electrically connected to the temperature sensor.

For example, the battery sensing unit 400 may include a first sensing extension 451. The first sensing extension 451 may extend from the sensing connector 430. For example, the first sensing extension 451 may extend from the first sensing connector 431. For example, the battery sensing unit 400 may include a second sensing extension 452. The second sensing extension 452 may extend from the sensing body 410.

The sensing extension 450 may include or indicate at least one of the first sensing extension 451 and the second sensing extension 452. The sensing extension 450 may be positioned between the sensing body 410 and the sensing connector 430. For example, the sensing extension 450 may be positioned between the sensing body 410 and the first sensing connector 431.

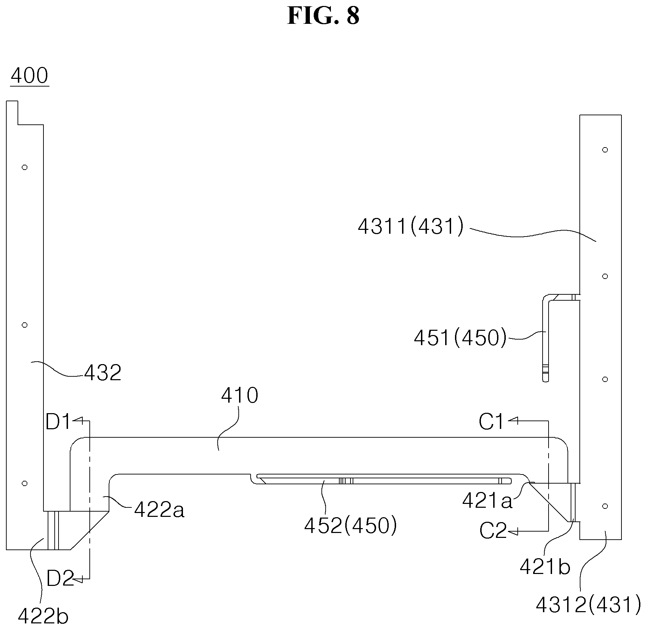

FIG. 8 illustrates that a battery sensing unit illustrated in FIG. 5 is folded along a fold line positioned on a sensing bridge. For convenience of explanation, the sensing extension 450 that is not fold may be illustrated in FIG. 8.

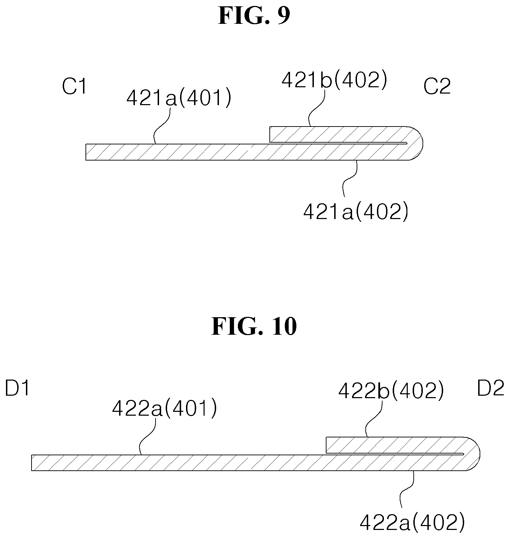

FIG. 9 is a cross-sectional view of a battery sensing unit taken along C1-C2 of FIG. 8. FIG. 10 is a cross-sectional view of a battery sensing unit taken along D1-D2 of FIG. 8.

Referring to FIGS. 8 to 10, the sensing bridge 420 may be folded along the fold line FL positioned on the sensing bridge 420.

In a process of folding the sensing bridge 420, the sensing body 410 and the sensing bridge proximal portions 421a and 422a may be fixed, and the sensing bridge distal portions 421b and 422b and the sensing connector 430 may move.

For example, in the process of folding the sensing bridge 420, the sensing bridge distal portions 421b and 422b and the sensing connector 430 may be turned over. In other words, in the process of folding the sensing bridge 420, a direction in which the first face 401 and a second face 402 of the sensing bridge distal portions 421b and 422b face may be interchanged, and a direction in which the first face 401 and the second face 402 of the sensing connector 430 face may be interchanged.

For example, through the process of folding the sensing bridge 420, the second faces 402 of the sensing bridge distal portions 421b and 422b and the second face 402 of the sensing connector 430 may be observed as shown in FIG. 8.

The sensing bridge proximal portions 421a and 422a may include at least one of the first sensing bridge proximal portion 421a and the second sensing bridge proximal portion 422a. The sensing bridge distal portions 421b and 422b may include at least one of the first sensing bridge distal portion 421b and the second sensing bridge distal portion 422b.

In the process of folding the sensing bridge 420, the second sensing extension 452 connected to the sensing body 410 may be fixed, and the first sensing extension 451 connected to the sensing connector 430 may move.

As the sensing bridge 420 is folded, a longitudinal direction of the sensing connector 430 may vary. For example, in a state in which the sensing bridge 420 is folded, the longitudinal direction of the sensing connector 430 may be a front-rear direction. For example, in a state in which the sensing bridge 420 is folded, the longitudinal direction of the sensing connector 430 may be the longitudinal direction of the battery module 10 (see FIG. 2).

As the sensing bridge 420 is folded, the arrangement of the sensing connector 430 and the sensing body 410 may vary. For example, in a state in which the sensing bridge 420 is folded, the sensing body 410 may be disposed between the first sensing connector 431 and the second sensing connector 432.

As the sensing bridge 420 is folded, the sensing bridge proximal portions 421a and 422a and the sensing bridge distal portions 421b and 422b may overlap. For example, as the sensing bridge 420 is folded, the sensing bridge proximal portions 421a and 422a and the sensing bridge distal portions 421b and 422b may face and contact each other.

For example, the sensing bridge 420 may be folded, and an adhesive may be disposed between the sensing bridge proximal portions 421a and 422a and the sensing bridge distal portions 421b and 422b. Hence, the sensing bridge proximal portions 421a and 422a and the sensing bridge distal portions 421b and 422b may be attached.

For example, the first faces 401 of the sensing bridge distal portions 421b and 422b and the first faces 401 of the sensing bridge proximal portions 421a and 422a may face and contact each other. For another example, the second faces 402 of the sensing bridge distal portions 421b and 422b and the second faces 402 of the sensing bridge proximal portions 421a and 422a may face and contact each other.

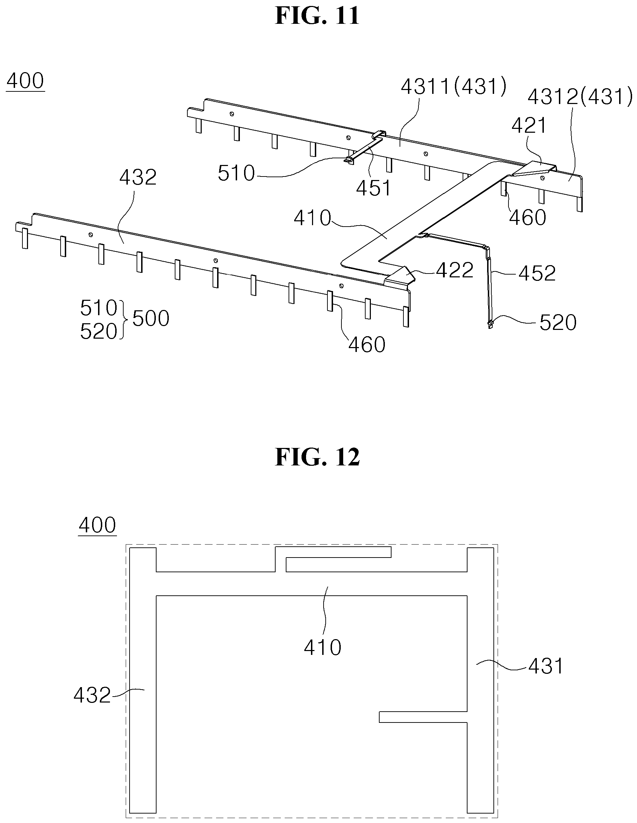

FIG. 11 illustrates that a battery sensing unit illustrated in FIG. 8 is bent.

Referring to FIGS. 5 to 11, the sensing bridge 420 may be bent along the bending line BL positioned on the sensing bridge 420. When the sensing bridge 420 is bent along the bending line BL positioned on the sensing bridge 420, a posture of the sensing connector 430 with respect to the sensing bridge 420 may be changed.

For example, one face of the sensing connector 430 may face or be directed toward the transverse direction of the battery module 10 (see FIG. 2). For example, the first surface 401 of the first sensing connector 431 and the second surface 402 of the second sensing connector 432 may face each other.

The battery sensing unit 400 may be coupled to the bus bar unit 300. For example, the first sensing connector 431 may face the first bus bar unit 310 (see FIG. 2). For example, the first sensing connector 431 may be coupled to the first bus bar unit 310 (see FIG. 2). For example, the first surface 401 of the first sensing connector 431 may be coupled to the first bus bar unit 310 (see FIG. 2).

For example, the second sensing connector 432 may face the second bus bar unit 320 (see FIG. 2). For example, the second sensing connector 432 may be coupled to the second bus bar unit 320 (see FIG. 2). For example, the first face 401 of the second sensing connector 432 may be coupled to the second bus bar unit 320 (see FIG. 2).

The battery sensing unit 400 may include a connector pin 460. The connector pin 460 may have electrical conductivity. For example, the connector pin 460 may include a conductive material such as metal. The connector pin 460 may be coupled to the sensing connector 430. For example, the connector pin 460 may be electrically connected to the sensing connector 430.

The connector pin 460 may be electrically connected to the bus bar unit 300. A voltage or current formed in the battery cell assembly 100 (see FIG. 2) may be applied to the bus bar unit 300 (see FIG. 2). A signal related to the voltage or the current applied to the bus bar unit 300 (see FIG. 2) may sequentially pass through the connector pin 460 and the sensing connector 430 and may be transmitted to the sensing body 410.

The battery module 10 (see FIG. 2) may include a temperature sensor 500. For example, the temperature sensor 500 may include a first temperature sensor 510 connected to the first sensing extension 451. For example, the temperature sensor 500 may include a second temperature sensor 520 connected to the second sensing extension 452.

The temperature sensor 500 may be in contact with or adjacent to the battery cell assembly 100 (see FIG. 2). For example, the first temperature sensor 510 may be in contact with or adjacent to an upper surface of the battery cell assembly 100 (see FIG. 2). For example, the second temperature sensor 520 may be in contact with or adjacent to a front face of the battery cell assembly 100 (see FIG. 2).

The temperature sensor 500 may obtain information on the temperature of the battery cell assembly 100 (see FIG. 2). For example, temperature information obtained by the first temperature sensor 510 may be transmitted through the first sensing extension 451 and the first sensing connector 431 to the sensing body 410. For example, temperature information obtained by the second temperature sensor 520 may be transmitted to the sensing body 410 via the second sensing extension 452.

Referring to FIGS. 1 to 11, the battery sensing unit 400 may include a FPCB. For example, the respective components of the battery sensing unit 400 may be formed as a unibody. For example, the sensing body 410, the sensing bridge 420, and the sensing connector 430 may be formed as a unibody. For example, the sensing body 410, the sensing bridge 420, the sensing connector 430, and the sensing extension 450 may be formed as a unibody.

Since the battery sensing unit 400 is formed as a unibody, the durability of the battery sensing unit 400 can relatively increase. For example, since the battery sensing unit 400 is formed as a unibody, it is possible to reinforce the connection between the sensing connector 430 and the sensing bridge 420 and the connection between the sensing bridge 420 and the sensing body 410.

FIG. 12 illustrates that an unfolded battery sensing unit is formed on one plane.

As illustrated in FIGS. 3 to 11, the battery sensing unit 400 may be formed by folding and bending an FPCB formed on a plane. As a result, an area of the FPCB required to form the battery sensing unit 400 can be relatively reduced.

For example, an area of the FPCB required for the unfolded battery sensing unit 400 illustrated in FIG. 12 may be larger than an area of the FPCB required for the folded and bent the battery sensing unit 400 illustrated in FIGS. 3 to 11.

The disclosed technology can be implemented in rechargeable secondary batteries that are widely used in battery-powered devices or systems, including, e.g., digital cameras, mobile phones, notebook computers, hybrid vehicles, electric vehicles, uninterruptible power supplies, battery storage power stations, and others including battery power storage for solar panels, wind power generators and other green tech power generators. Specifically, the disclosed technology can be implemented in some embodiments to provide improved electrochemical devices such as a battery used in various power sources and power supplies, thereby mitigating climate changes in connection with uses of power sources and power supplies. Lithium secondary batteries based on the disclosed technology can be used to address various adverse effects such as air pollution and greenhouse emissions by powering electric vehicles (EVs) as alternatives to vehicles using fossil fuel-based engines and by providing battery-based energy storage systems (ESSs) to store renewable energy such as solar power and wind power.

Some embodiments or other embodiments of the disclosed technology described above are not mutually exclusive or distinct from each other. Configurations or functions of some embodiments or other embodiments of the disclosed technology described above can be used together or combined with each other.

Only specific examples of implementations of certain embodiments are described. Variations, improvements and enhancements of the disclosed embodiments and other embodiments may be made based on the disclosure of this patent document.

## Claims

1. A battery sensing unit (400) for sensing a status of a battery module (10), the battery sensing unit (400) forming a first face (401) and a second face (402) which are opposite to each other, the battery sensing unit (400) comprising:
a sensing body (410) including a first end and a second end that oppose each other and extending from the first end to the second end in a transverse direction of the battery sensing unit (400);
a first sensing bridge (421) extending forward from the first end of the sensing body (410);
a second sensing bridge (422) extending forward from the second end of the sensing body (410);
a first sensing connector (431) forming a shape extending from an end of the first sensing bridge (421) toward the second sensing bridge (422); and
a second sensing connector (432) forming a shape extending from an end of the second sensing bridge (422) toward the first sensing bridge (421),
wherein the first sensing connector (431) is positioned between the sensing body (410) and the second sensing connector (432),
wherein the first sensing bridge (421) includes a first sensing bridge proximal portion (421a) extending from the sensing body (410) and a first sensing bridge distal portion (421b) extending from the first sensing bridge proximal portion (421a),
wherein the second sensing bridge (422) includes a second sensing bridge proximal portion (422a) extending from the sensing body (410) and a second sensing bridge distal portion (422b) extending from the second sensing bridge proximal portion (422a),
wherein in a state in which: a first sensing bridge (421) is folded at a boundary between the first sensing bridge proximal portion (421a) and the first sensing bridge distal portion (421b); the first sensing bridge distal portion (421b) is bent; a second sensing bridge (422) is folded at a boundary between the second sensing bridge proximal portion (422a) and the second sensing bridge distal portion (422b); and the second sensing bridge distal portion (422b) is bent, each of the first sensing connector (431) and the second sensing connector (432) extends in a longitudinal direction, and the first face (401) of the first sensing connector (431) faces the first face (401) of the second sensing connector (432).

2. The battery sensing unit (400) of claim 1, wherein the first sensing bridge (421) is bent between a folded portion of the first sensing bridge (421) and the first sensing connector (431), and
wherein the second sensing bridge (422) is bent between a folded portion of the second sensing bridge (422) and the second sensing connector (432).

3. The battery sensing unit (400) of claim 1, further comprising:
a first sensing extension (451) extending from the first sensing connector (431); and
a second sensing extension (452) extending from the sensing body (410).

4. The battery sensing unit (400) of claim 1, wherein the sensing body (410), the first sensing bridge (421), the second sensing bridge (422), the first sensing connector (431), and the second sensing connector (432) are formed as a unibody.

5. The battery sensing unit (400) of claim 1, wherein the sensing body (410), the first sensing bridge (421), the second sensing bridge (422), the first sensing connector (431), and the second sensing connector (432) includes a flexible printed circuit board (FPCB).

6. A battery module (10) comprising:
a battery cell assembly (100) including a plurality of battery cells arranged in a front-rear direction of the battery cell assembly (100), each of the plurality of battery cells including a first electrode lead and a second electrode lead that protrude in a first direction and are formed opposite to each other;
a first bus bar unit (310) coupled to the first electrode lead;
a second bus bar unit (320) coupled to the second electrode lead; and
a battery sensing unit (400) according to any one of claims 1 to 5, configured to connect the first bus bar unit (310) and the second bus bar unit (320) and operable to sense a status of the battery cell assembly (100), the battery sensing unit (400) forming a first face (401) and a second face (402) which are opposite to each other,
wherein the battery sensing unit (400) includes:
a first sensing connector (431) extending in the front-rear direction, the first face (401) of the first sensing connector (431) being coupled to the first bus bar unit (310);
a second sensing connector (432) extending in the front-rear direction, the first face (401) of the second sensing connector (432) being coupled to the second bus bar unit (320);
a sensing body (410) extending in the first direction;
a first sensing bridge (421) configured to connect a first end of the sensing body (410) to the first sensing connector (431), the first sensing bridge (421) being folded and bent; and
a second sensing bridge (422) configured to connect a second end of the sensing body (410) to the second sensing connector (432), the second sensing bridge (422) being folded and bent,
wherein the first sensing bridge (421) includes a first sensing bridge proximal portion (421a) extending from the sensing body (410) and a first sensing bridge distal portion (421b) extending from the first sensing bridge proximal portion (421a),
wherein the second sensing bridge (422) includes a second sensing bridge proximal portion (422a) extending from the sensing body (410) and a second sensing bridge distal portion (422b) extending from the second sensing bridge proximal portion (422a).

7. The battery module (10) of claim 6, wherein the battery sensing unit (400) includes a flexible printed circuit board (FPCB).

8. The battery module (10) of claim 7, wherein the sensing body (410), the first sensing bridge (421), the second sensing bridge (422), the first sensing connector (431), and the second sensing connector (432) are formed as a unibody.

9. The battery module (10) of claim 6, wherein the first sensing bridge (421) is bent between a folded portion of the first sensing bridge (421) and the first sensing connector (431), and
wherein the second sensing bridge (422) is bent between a folded portion of the second sensing bridge (422) and the second sensing connector (432).

10. The battery module (10) of claim 6, wherein the battery sensing unit (400) further includes:
a first sensing extension (451) extending from the first sensing connector (431); and
a second sensing extension (452) extending from the sensing body (410).

11. The battery module (10) of claim 10, wherein the battery sensing unit (400) includes at least one of:
a first temperature sensor (510) connected to the first sensing extension (451) and operable to measure a temperature of the battery cell assembly (100); or
a second temperature sensor (520) connected to the second sensing extension (452) and operable to measure a temperature of the battery cell assembly (100).

## Patentansprüche

1. Batteriesensoreinheit (400) zum Erfassen eines Status eines Batteriemoduls (10), wobei die Batteriesensoreinheit (400) eine erste Fläche (401) und eine zweite Fläche (402) bildet, die einander gegenüberliegen, wobei die Batteriesensoreinheit (400) Folgendes umfasst:
einen Sensorkörper (410), der ein erstes Ende und ein zweites Ende umfasst, die einander gegenüberliegen, und sich von dem ersten Ende zu dem zweiten Ende in einer Querrichtung der Batteriesensoreinheit (400) erstreckt;
eine erste Sensorbrücke (421), die sich von dem ersten Ende des Sensorkörpers (410) nach vorne erstreckt;
eine zweite Sensorbrücke (422), die sich von dem zweiten Ende des Sensorkörpers (410) nach vorne erstreckt;
einen ersten Sensorverbinder (431), der eine Form bildet, die sich von einem Ende der ersten Sensorbrücke (421) zu der zweiten Sensorbrücke (422) hin erstreckt; und
einen zweiten Sensorverbinder (432), der eine Form bildet, die sich von einem Ende der zweiten Sensorbrücke (422) zu der ersten Sensorbrücke (421) hin erstreckt,
wobei der erste Sensorverbinder (431) zwischen dem Sensorkörper (410) und dem zweiten Sensorverbinder (432) positioniert ist,
wobei die erste Sensorbrücke (421) einen proximalen Abschnitt (421a) der ersten Sensorbrücke, der sich von dem Sensorkörper (410) erstreckt, und einen distalen Abschnitt (421b) der ersten Sensorbrücke, der sich von dem proximalen Abschnitt (421a) der ersten Sensorbrücke erstreckt, umfasst,
wobei die zweite Sensorbrücke (422) einen proximalen Abschnitt (422a) der zweiten Sensorbrücke, der sich von dem Sensorkörper (410) erstreckt, und einen distalen Abschnitt (422b) der zweiten Sensorbrücke, der sich von dem proximalen Abschnitt (422a) der zweiten Sensorbrücke erstreckt, umfasst,
wobei in einem Zustand, in dem: eine erste Sensorbrücke (421) an einer Grenze zwischen dem proximalen Abschnitt (421a) der ersten Sensorbrücke und dem distalen Abschnitt (421b) der ersten Sensorbrücke gefaltet ist; der distale Abschnitt (421b) der ersten Sensorbrücke gebogen ist;
eine zweite Sensorbrücke (422) an einer Grenze zwischen dem proximalen Abschnitt (422a) der zweiten Sensorbrücke und dem distalen Abschnitt (422b) der zweiten Sensorbrücke gefaltet ist; und der distale Abschnitt (422b) der zweiten Sensorbrücke gebogen ist, sich der erste Sensorverbinder (431) und der zweite Sensorverbinder (432) jeweils in einer Längsrichtung erstrecken und die erste Fläche (401) des ersten Sensorverbinders (431) der ersten Fläche (401) des zweiten Sensorverbinders (432) zugewandt ist.

2. Batteriesensoreinheit (400) nach Anspruch 1, wobei die erste Sensorbrücke (421) zwischen einem gefalteten Abschnitt der ersten Sensorbrücke (421) und dem ersten Sensorverbinder (431) gebogen ist, und
wobei die zweite Sensorbrücke (422) zwischen einem gefalteten Abschnitt der zweiten Sensorbrücke (422) und dem zweiten Sensorverbinder (432) gebogen ist.

3. Batteriesensoreinheit (400) nach Anspruch 1, die ferner Folgendes umfasst:
eine erste Sensorverlängerung (451), die sich von dem ersten Sensorverbinder (431) erstreckt; und
eine zweite Sensorverlängerung (452), die sich von dem Sensorkörper (410) erstreckt.

4. Batteriesensoreinheit (400) nach Anspruch 1, wobei der Sensorkörper (410), die erste Sensorbrücke (421), die zweite Sensorbrücke (422), der erste Sensorverbinder (431) und der zweite Sensorverbinder (432) als ein Einheitskörper gebildet sind.

5. Batteriesensoreinheit (400) nach Anspruch 1, wobei der Sensorkörper (410), die erste Sensorbrücke (421), die zweite Sensorbrücke (422), der erste Sensorverbinder (431) und der zweite Sensorverbinder (432) eine flexible Leiterplatte (FPCB) umfassen.

6. Batteriemodul (10), das Folgendes umfasst:
eine Batteriezellenanordnung (100), die mehrere Batteriezellen umfasst, die in einer Richtung der Batteriezellenanordnung (100) von vorn nach hinten angeordnet sind, wobei jede der mehreren Batteriezellen eine erste Elektrodenleitung und eine zweite Elektrodenleitung umfasst, die in einer ersten Richtung vorstehen und entgegengesetzt zueinander gebildet sind;
eine erste Sammelschieneneinheit (310), die mit der ersten Elektrodenleitung gekoppelt ist;
eine zweite Sammelschieneneinheit (320), die mit der zweiten Elektrodenleitung gekoppelt ist; und
eine Batteriesensoreinheit (400) nach einem der Ansprüche 1 bis 5, die dazu ausgelegt ist, die erste Sammelschieneneinheit (310) und die zweite Sammelschieneneinheit (320) zu verbinden, und dazu betreibbar ist, einen Status der Batteriezellenanordnung (100) zu erfassen, wobei die Batteriesensoreinheit (400) eine erste Fläche (401) und eine zweite Fläche (402) bildet, die einander gegenüberliegen,
wobei die Batteriesensoreinheit (400) Folgendes umfasst: einen ersten Sensorverbinder (431), der sich in der Richtung von vorn nach hinten erstreckt, wobei die erste Fläche (401) des ersten Sensorverbinders (431) mit der ersten Sammelschieneneinheit (310) gekoppelt ist;
einen zweiten Sensorverbinder (432), der sich in der Richtung von vorn nach hinten erstreckt, wobei die erste Fläche (401) des zweiten Sensorverbinders (432) mit der zweiten Sammelschieneneinheit (320) gekoppelt ist;
einen Sensorkörper (410), der sich in der ersten Richtung erstreckt;
eine erste Sensorbrücke (421), die dazu ausgelegt ist, ein erstes Ende des Sensorkörpers (410) mit dem ersten Sensorverbinder (431) zu verbinden, wobei die erste Sensorbrücke (421) gefaltet und gebogen ist; und
eine zweite Sensorbrücke (422), die dazu ausgelegt ist, ein zweites Ende des Sensorkörpers (410) mit dem zweiten Sensorverbinder (432) zu verbinden, wobei die zweite Sensorbrücke (422) gefaltet und gebogen ist,
wobei die erste Sensorbrücke (421) einen proximalen Abschnitt (421a) der ersten Sensorbrücke, der sich von dem Sensorkörper (410) erstreckt, und einen distalen Abschnitt (421b) der ersten Sensorbrücke, der sich von dem proximalen Abschnitt (421a) der ersten Sensorbrücke erstreckt, umfasst,
wobei die zweite Sensorbrücke (422) einen proximalen Abschnitt (422a) der zweiten Sensorbrücke, der sich von dem Sensorkörper (410) erstreckt, und einen distalen Abschnitt (422b) der zweiten Sensorbrücke, der sich von dem proximalen Abschnitt (422a) der zweiten Sensorbrücke erstreckt, umfasst.

7. Batteriemodul (10) nach Anspruch 6, wobei die Batteriesensoreinheit (400) eine flexible Leiterplatte (FPCB) umfasst.

8. Batteriemodul (10) nach Anspruch 7, wobei der Sensorkörper (410), die erste Sensorbrücke (421), die zweite Sensorbrücke (422), der erste Sensorverbinder (431) und der zweite Sensorverbinder (432) als ein Einheitskörper gebildet sind.

9. Batteriemodul (10) nach Anspruch 6, wobei die erste Sensorbrücke (421) zwischen einem gefalteten Abschnitt der ersten Sensorbrücke (421) und dem ersten Sensorverbinder (431) gebogen ist, und
wobei die zweite Sensorbrücke (422) zwischen einem gefalteten Abschnitt der zweiten Sensorbrücke (422) und dem zweiten Sensorverbinder (432) gebogen ist.

10. Batteriemodul (10) nach Anspruch 6, wobei die Batteriesensoreinheit (400) ferner Folgendes umfasst:
eine erste Sensorverlängerung (451), die sich von dem ersten Sensorverbinder (431) erstreckt; und
eine zweite Sensorverlängerung (452), die sich von dem Sensorkörper (410) erstreckt.

11. Batteriemodul (10) nach Anspruch 10, wobei die Batteriesensoreinheit (400) mindestens eines von Folgendem umfasst:
einen ersten Temperatursensor (510), der mit der ersten Sensorverlängerung (451) verbunden und dazu betreibbar ist, eine Temperatur der Batteriezellenanordnung (100) zu messen; oder
einen zweiten Temperatursensor (520), der mit der zweiten Sensorverlängerung (452) verbunden und dazu betreibbar ist, eine Temperatur der Batteriezellenanordnung (100) zu messen.

## Revendications

1. Unité de détection de batterie (400) pour détecter un état d'un module de batterie (10), l'unité de détection de batterie (400) formant une première face (401) et une seconde face (402) qui sont opposées l'une à l'autre, l'unité de détection de batterie (400) comprenant :
un corps de détection (410) comprenant une première extrémité et une seconde extrémité opposées l'une à l'autre et s'étendant de la première extrémité à la seconde extrémité dans une direction transversale de l'unité de détection de batterie (400) ;
un premier pont de détection (421) s'étendant vers l'avant à partir de la première extrémité du corps de détection (410) ;
un second pont de détection (422) s'étendant vers l'avant à partir de la seconde extrémité du corps de détection (410) ;
un premier connecteur de détection (431) formant une forme s'étendant à partir d'une extrémité du premier pont de détection (421) vers le second pont de détection (422) ; et
un second connecteur de détection (432) formant une forme s'étendant à partir d'une extrémité du second pont de détection (422) vers le premier pont de détection (421), dans lequel le premier connecteur de détection (431) est positionné entre le corps de détection (410) et le second connecteur de détection (432),
dans lequel le premier pont de détection (421) comprend une partie proximale (421a) de premier pont de détection s'étendant à partir du corps de détection (410) et une partie distale (421b) de premier pont de détection s'étendant à partir de la partie proximale (421a) de premier pont de détection,
dans lequel le second pont de détection (422) comprend une partie proximale (422a) de second pont de détection s'étendant à partir du corps de détection (410) et une partie distale (422b) de second pont de détection s'étendant à partir de la partie proximale (422a) de second pont de détection,
dans laquelle, dans un état dans lequel : un premier pont de détection (421) est plié au niveau d'une limite entre la partie proximale (421a) de premier pont de détection et la partie distale (421b) de premier pont de détection ; la partie distale (421b) de premier pont de détection est fléchie ; un second pont de détection (422) est plié au niveau d'une limite entre la partie proximale (422a) de second pont de détection et la partie distale (422b) de second pont de détection ; et la partie distale (422b) de second pont de détection est fléchie, le premier connecteur de détection (431) et le second connecteur de détection (432) s'étendent chacun dans une direction longitudinale, et la première face (401) du premier connecteur de détection (431) fait face à la première face (401) du second connecteur de détection (432).

2. Unité de détection de batterie (400) selon la revendication 1, dans laquelle le premier pont de détection (421) est fléchi entre une partie pliée du premier pont de détection (421) et le premier connecteur de détection (431), et
dans laquelle le second pont de détection (422) est fléchi entre une partie pliée du second pont de détection (422) et le second connecteur de détection (432).

3. Unité de détection de batterie (400) selon la revendication 1, comprenant en outre :
une première extension de détection (451) s'étendant à partir du premier connecteur de détection (431) ; et
une seconde extension de détection (452) s'étendant à partir du corps de détection (410).

4. Unité de détection de batterie (400) selon la revendication 1, dans laquelle le corps de détection (410), le premier pont de détection (421), le second pont de détection (422), le premier connecteur de détection (431) et le second connecteur de détection (432) sont formés en tant que corps unique.

5. Unité de détection de batterie (400) selon la revendication 1, dans laquelle le corps de détection (410), le premier pont de détection (421), le second pont de détection (422), le premier connecteur de détection (431) et le second connecteur de détection (432) comprennent une carte de circuit imprimé flexible (FPCB).

6. Module de batterie (10) comprenant :
un ensemble d'éléments de batterie (100) comprenant une pluralité d'éléments de batterie disposés dans le sens avant-arrière de l'ensemble d'éléments de batterie (100), chaque élément de la pluralité d'éléments de batterie comprenant un premier fil d'électrode et un second fil d'électrode qui font saillie dans une première direction et sont formés à l'opposé l'un de l'autre ;
une première unité de barre omnibus (310) couplée au premier fil d'électrode ;
une seconde unité de barre omnibus (320) couplée au second fil d'électrode ; et
une unité de détection de batterie (400) selon l'une quelconque des revendications 1 à 5, configurée pour connecter la première unité de barre omnibus (310) et la seconde unité de barre omnibus (320) et pouvant fonctionner pour détecter un état de l'ensemble d'éléments de batterie (100), l'unité de détection de batterie (400) formant une première face (401) et une seconde face (402) qui sont opposées l'une à l'autre,
dans lequel l'unité de détection de batterie (400) comprend :
un premier connecteur de détection (431) s'étendant dans le sens avant-arrière, la première face (401) du premier connecteur de détection (431) étant couplée à la première unité de barre omnibus (310) ;
un second connecteur de détection (432) s'étendant dans le sens avant-arrière, la première face (401) du second connecteur de détection (432) étant couplée à la seconde unité de barre omnibus (320) ;
un corps de détection (410) s'étendant dans la première direction ;
un premier pont de détection (421) configuré pour connecter une première extrémité du corps de détection (410) au premier connecteur de détection (431), le premier pont de détection (421) étant plié et fléchi ; et
un second pont de détection (422) configuré pour connecter une seconde extrémité du corps de détection (410) au second connecteur de détection (432), le second pont de détection (422) étant plié et fléchi,
dans lequel le premier pont de détection (421) comprend une partie proximale (421a) de premier pont de détection s'étendant à partir du corps de détection (410) et une partie distale (421b) de premier pont de détection s'étendant à partir de la partie proximale (421a) de premier pont de détection,
dans lequel le second pont de détection (422) comprend une partie proximale (422a) de second pont de détection s'étendant à partir du corps de détection (410) et une partie distale (422b) de second pont de détection s'étendant à partir de la partie proximale (422a) de second pont de détection.

7. Module de batterie (10) selon la revendication 6, dans lequel l'unité de détection de batterie (400) comprend une carte de circuit imprimé flexible (FPCB).

8. Module de batterie (10) selon la revendication 7, dans lequel le corps de détection (410), le premier pont de détection (421), le second pont de détection (422), le premier connecteur de détection (431) et le second connecteur de détection (432) sont formés en tant que corps unique.

9. Module de batterie (10) selon la revendication 6, dans lequel le premier pont de détection (421) est fléchi entre une partie pliée du premier pont de détection (421) et le premier connecteur de détection (431), et
dans laquelle le second pont de détection (422) est fléchi entre une partie pliée du second pont de détection (422) et le second connecteur de détection (432).

10. Module de batterie (10) selon la revendication 6, dans lequel l'unité de détection de batterie (400) comprend en outre :
une première extension de détection (451) s'étendant à partir du premier connecteur de détection (431) ; et
une seconde extension de détection (452) s'étendant à partir du corps de détection (410).

11. Module de batterie (10) selon la revendication 10, dans lequel l'unité de détection de batterie (400) comprend au moins l'un parmi :
un premier capteur de température (510) connecté à la première extension de détection (451) et pouvant fonctionner pour mesurer une température de l'ensemble d'éléments de batterie (100) ; ou
un second capteur de température (520) relié à la seconde extension de détection (452) et pouvant fonctionner pour mesurer une température de l'ensemble d'éléments de batterie (100).
